Europäisches Patentamt

**European Patent Office**

**Office européen des brevets**

(11) Publication number: **0 026 568**
**B1**

# EUROPEAN PATENT SPECIFICATION

(45) Date of publication of patent specification: **30.03.83**

(21) Application number: **80302714.3**

(22) Date of filing: **07.08.80**

(51) Int. Cl.³: **H 01 R 23/66,**
**H 01 R 13/193**

(54) Connector for connecting conductors of a flat cable to conductors on a substrate.

(30) Priority: **07.09.79 US 73402**
**07.05.80 US 147667**

(43) Date of publication of application:
**08.04.81 Bulletin 81/14**

(45) Publication of the grant of the patent:
**30.03.83 Bulletin 83/13**

(84) Designated Contracting States:
**AT BE CH DE FR GB IT LI NL SE**

(56) References cited:
**GB - A - 2 028 015**
**US - A - 3 989 336**
**US - A - 4 054 348**
**US - A - 4 181 386**

(73) Proprietor: **AMP INCORPORATED**
**Eisenhower Boulevard**
**Harrisburg Pennsylvania (US)**

(72) Inventor: **Reynolds, Charles Edward**
**6216 Whitehill Drive**
**Mechanicsburg Pennsylvania (US)**
Inventor: **Whiteman, Robert Neil, Jr.**
**1031 Plane Street**
**Middletown Pennsylvania 17057 (US)**

(74) Representative: **Wayte, Dennis Travers et al,**
**20 Queensmere**
**Slough, Berkshire SL1 1YZ (GB)**

Connector for connecting conductors of a flat cable to
conductors on a substrate

This invention relates to a connector, and particularly a connector for use in establishing electrical connections between the conductors of a flat multi-conductor electrical cable and conductors carried by a substrate.

Such a connector is disclosed in French Patent Application No. 73.14613, Publication No. 2241888, which discloses a connector comprising a single member stamped and formed from sheet metal and having an elongate body portion, a plurality of resilient fingers arranged in a row extending lengthwise of the body portion, all the fingers extending in the same direction and having their longitudinal axes extending transversely of the row direction, and mounting means formed at each end of the body portion and adapted and arranged to secure the connector to a substrate with the fingers extending towards and engaging conductors carried by the substrate.

For use of this known connector, exposed end portions of the conductors of a flat multi-conductor cable comprising a plurality of parallel conductors carried by a sheet of insulating material, are clamped between the fingers and conductors on the surface of a substrate, for example a printed circuit board, the fingers thus serving to urge the cable conductors into engagement with the substrate conductors respectively, to provide the required connections.

With this known connector the fingers are arranged to point away from the edge of the substrate at which the connector is to be mounted, that is towards the cable to be connected to the substrate, and thus the connector can be mounted only at an edge of a substrate with the cable and connector being simultaneously applied to the substrate with the mounting means of the connector entering slots open to the edge of the substrate. This is because if the connector is first mounted on to the substrate without the cable, then the end of cable cannot subsequently be inserted between the fingers and the substrate since the free ends of the fingers are directed towards the cable and are in engagement with the substrate.

This known connector thus has the disadvantages that as disclosed it can be used only at an edge of a substrate, and must be assembled to a substrate simultaneously with a cable, and must also be removed from the substrate when the cable is to be removed.

U.S. Patent Specification No. 3629787 discloses a connector which serves the same purpose as the connector discussed above, and which comprises a housing of insulating material adapted to be secured to an end of a substrate having conductors on a surface thereof, the housing containing a finger structure stamped and formed from sheet metal and comprising a plurality of resilient fingers extending from one edge of a body portion, the fingers being reversely bent to underlie the body portion. In use, the housing is secured to the substrate with exposed end portions of the conductors of a cable as described above positioned between the conductors on the substrate and the fingers such that the fingers are compressed and serve to urge the cable conductors into engagement with the substrate conductors to provide the required connections.

This known connector has the disadvantages that it consists of a plurality of different parts which must be assembled together, and that no provision is made for zero force insertion of a cable end between the fingers and the substrate if the connector is mounted on the substrate prior to insertion of the cable end.

In European Patent Application No. 79301163.6, Publication No. EP—A—6721, there is disclosed a connector of the type disclosed in the above mentioned French Patent Application, in which the fingers extend from one longitudinal edge of the body portion and are reversely bent to underlie the body portion, the mounting means comprising a plurality of tabs adapted to pass through holes in the substrate and thereafter to be bent to engage the surface of the substrate remote from the surface engaged by the fingers.

This connector has the advantages that it is cheap and simple to manufacture, and can easily be mounted on a substrated at any required position, not needing to be at an edge of the substrate. Further, the connector can easily be adapted for zero force insertion of a cable end between the fingers and a substrate on which the connector is mounted, and the connector does not have to be disassembled in any way when the cable is to be removed.

To this end the free ends of the fingers are adapted and arranged to be engageable by a tool in the form of a separate piece of sheet material which is inserted under the free ends of the fingers and over flanges formed at the ends of the body portion, whereby when pressure is applied on the outer end of the tool towards the substrate on which the connector is mounted the tool acts to lift the fingers out of engagement with the substrate, with the flanges acting as pivot points for the tool, such that the treated end portion of a cable can be inserted between the fingers and the substrate with zero force. Subsequent removal of the tool allows the fingers to engage the inserted cable and urge it into contact with the substrate as required.

This arrangement has the disadvantages that it requires the use of the separate tool which can be lost, and that access to the edge of the connector at which the free ends of the fingers are accessible, is required, this possibly requiring wasted space on the substrate on which the connector is mounted.

The first of these disadvantages is overcome by a construction of connector disclosed in the noted application, in which the fingers are made of such a length that they extend outside of the body portion such that they can be manually operated to permit zero force insertion of a cable end between the fingers and a substrate on which the connector is mounted. However, this construction introduces the further disadvantages that the overall size of the connector is increased such that the connector requires an increased area of the substrate at all times and not only when a tool is engaged therewith as previously described, and that the fingers can be difficult to lift since they are directly engaged manually and without the mechanical advantage of any lever arrangement.

Further, with all these known connectors it is not possible for the fingers to be latched disengaged from the substrate, it being necessary for manual pressure to be maintained if this is to be achieved. Such latching of the fingers may be desirable in order to avoid interconnecting the conductors on the substrate when no cable is connected to the connector.

According to this invention there is provided a connector, for use in establishing electrical connections between the conductors of a flat multi-conductor electrical cable and conductors carried by a substrate, the connector comprising an elongate body member stamped and formed from sheet metal and having a plurality of resilient fingers arranged in a row extending lengthwise of the body member, the fingers all extending in the same direction from one longitudinal edge of the body member with their longitudinal axes extending transversely of the row direction, each finger being reversely bent to underlie the body member, and the body member being formed with mounting means comprising a plurality of tabs adapted to pass through holes in a substrate on which the connector is mounted and thereafter to be bent to engage the surface of the substrate remote from the surface of the substrate carrying the conductors, the fingers then extending towards and engaging the conductors carried by the substrate, characterised by a lifting lever mounted on the body member and engageable with the fingers, the lifting lever being movable relative to the body member, when the connector is mounted on a substrate, between a first position in which the lifting lever engages the fingers and lifts them out of contact with the substrate, and a second position in which the fingers are permitted to engage the substrate.

This invention will now be described by way of example with reference to the drawings, in which:—

Figure 1 is a perspective view of a first connector according to this invention mounted on a substrate;

Figure 2 is a sectional view on the line II—II in Figure 1 and showing a cable for connection to the substrate by the connector;

Figure 3 is a view similar to Figure 2 but showing the cable connected to the substrate by the connector;

Figure 4 is a sectional view on the line IV—IV in Figure 1;

Figure 5 is a perspective view of a second connector according to this invention mounted on a substrate and with a cable to be connected thereby;

Figure 6 is a view similar to Figure 5 but showing the connector with part detached;

Figure 7 is a section on the line VII—VII in Figure 5 but with the cable connected; and

Figure 8 is a view similar to Figure 7 but showing the connector in a different condition.

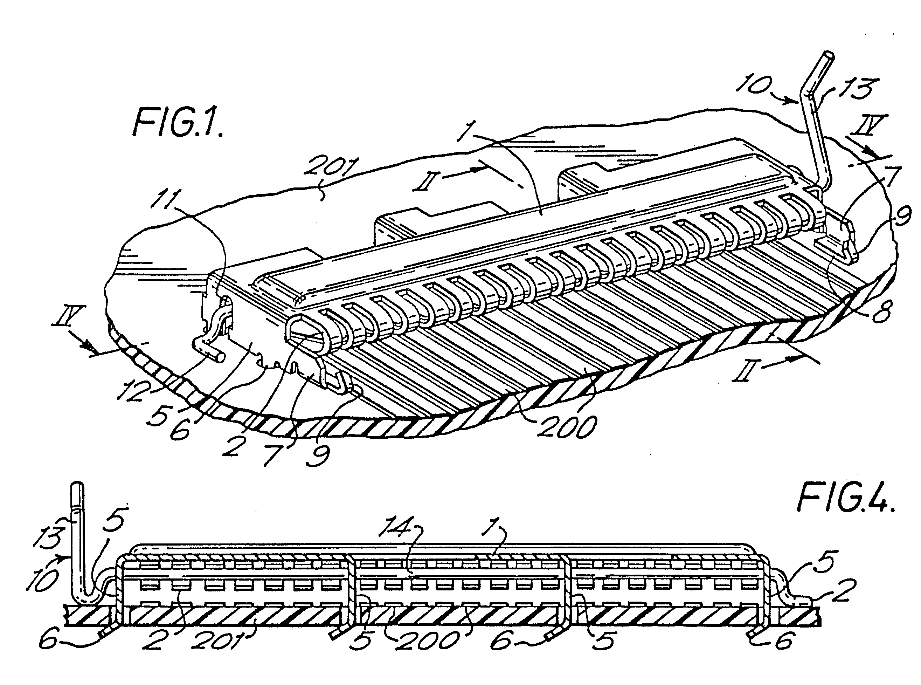

Referring to Figures 1 to 4, the connector here shown is for use in establishing electrical connections between the conductors 100 of a flat multi-conductor electrical cable 101, and conductors 200 carried by a substrate 201.

The connector is stamped and formed from sheet metal to comprise an elongate body member 1 having a plurality of resilient fingers 2 arranged in a row extending lengthwise of the body member 1. All the fingers 2 extend in the same direction from one longitudinal edge of the body member 1 with their longitudinal axes extending transversely of the row direction. Each finger 2 is bent to underlie the body member 1, and intermediate its ends is formed with a rounded projection 3 directed away from the body member 1. Beyond the projection 3 each finger 2 is again bent to extend first towards the body member 1 and then to provide a tail portion 4 extending substantially parallel to the body member 1 and away from the root of the finger 2.

At each end and intermediate its ends the body member 1 is formed with flanges 5 which extend to the same side of the body member 1 as the fingers 2, the flanges 5 being formed at their free ends with tabs 6. The end flanges 5 have extensions 7 extending beyond the reverse bends in the fingers 2, these extensions 7 carrying inwardly formed platforms 8 the outer ends of which are bent to form hooks 9 open towards the body member 1.

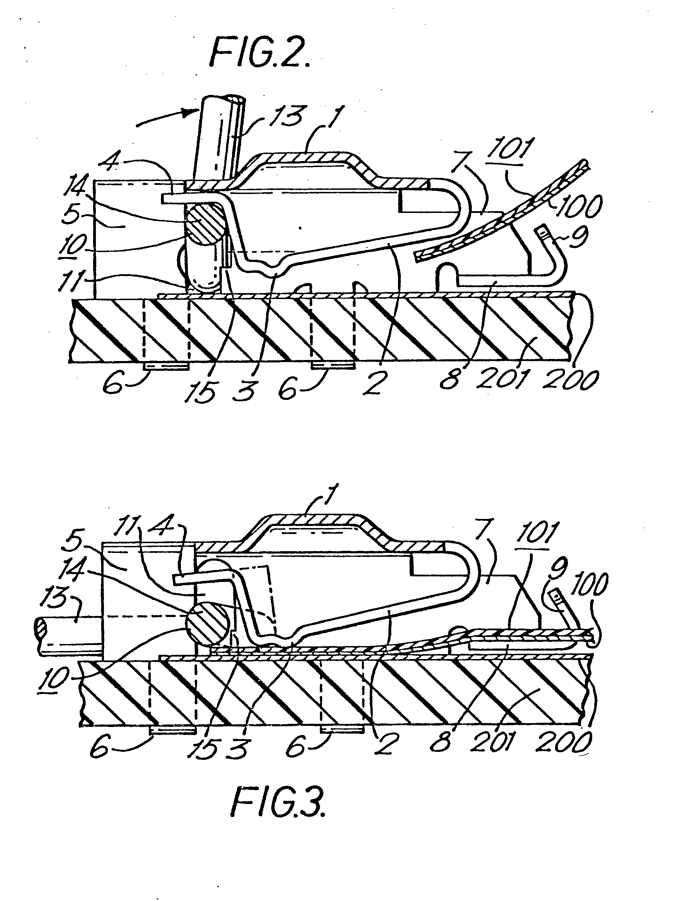

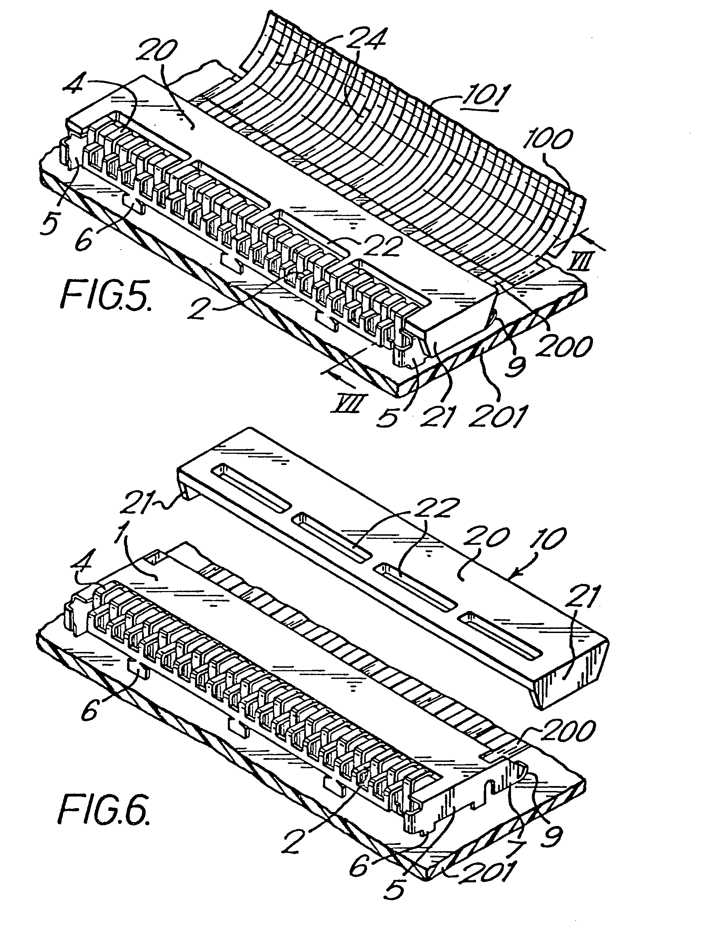

For use, the connector is mounted on the substrate 201 by the tabs 6 on the flanges 5 being passed through holes in the substrate 201 and then being bent, as shown in Figures 2 to 4, to embrace the underside of the substrate 201. The connector is so mounted on the substrate, with the fingers 2 aligned with respective conductors 200 on the substrate 201, as shown in Figures 1 and 4. The substrate 201 and conductors 200 can be constituted by a printed circuit board. The fingers 2 are such that their resilience urges them towards and against the associated conductors 200 on the substrate 201.

The connector is completed by a lifting lever 10 made of stiff wire and in the form of a crank.

The lever 10 passes through slots 11 in the flanges 5 of the body member and extends beyond both end flanges 5 where it engages the substrate 201 when the connector is mounted thereon. End portions 12 and 13 of the lever 10 are bent to extend at right-angles to the longitudinal axis of the body member 1 and also at right-angles to each other, to provide a crank portion 14 underlying the body member 1.

Each slot 11 has its mouth restricted by an ear 15, the width of the mouth being slightly less than the diameter of the lever 10 while the remainder of the slot 11 just receives the lever 10. The lever 10 is assembled to the body member 1 prior to mounting of the connector on the substrate 201, the lever 10 being urged into the slots 11 with the flanges 5 flexing to permit entry. When the connector is subsequently secured to the substrate 201 the flanges cannot flex and the lever 10 is retained in the slots 11 with the ears 15 limiting movement of the crank portion 14 of the lever towards the substrate 201. As indicated in Figure 3, the crank portion 14 of the lever is bowed slightly.

The bends in the lever 10 and the slots 11 in the flanges 5 are such that the lever 10 is rotatable using the end portion 13 as a handle, about the axis of the ends of its crank portion 14 between a first position, shown in Figures 1 and 2, in which the end portion 12 of the lever 10 is in contact with the substrate 201 to prevent further rotation of the lever 10 in one direction (clockwise in Figures 2 and 3) relative to the body member 1, and the crank portion 14 is raised relative to the substrate 201 and is in engagement with the tail portions 4 of the fingers 2 to lift the projections 3 out of contact with the substrate 201 (as shown in Figures 2 and 4) the bow in the crank portion 14 strengthening it against the action of the fingers 2, and a second position, shown in Figure 3, in which the end portion 13 of the lever 10 is in contact with the substrate 20 to prevent further rotation of the lever 10 in the other direction (anticlockwise in Figures 2 and 3) and the crank portion 14 is lowered relative to the substrate 201 and is clear of the fingers 2 such that the projections 3 on the fingers 2 are resiliently biased against the substrate 201.

During rotation of the lever 10 the portions thereof outside the outer flanges 5 of the body member 1 slide on the substrate 201, and act as cams to effect the raising and lowering of the crank portion 14 relative to the substrate 201.

With the lever 10 in the first position shown in Figures 1, 2 and 4 the prepared end of the cable 101 (Figure 2), that is the cable with the insulation removed from one side over an end portion to expose the conductors 100, can be inserted between the fingers 2 and the substrate 201, from the side remote from the free ends of the fingers 2, with zero insertion force and with the conductors 100 of the cable 101 aligned with respective conductors 200 on the substrate 201. The lever 10 is then rotated to the second position shown in Figure 3 such that the fingers 2 are released by the lever 10 and the fingers act on the insulated side of the cable 101 to urge the cable conductors 100 into contact with the associated substrate conductors 200 as required.

As can be seen from Figure 2, when the lever 10 is in its first position the crank portion 14 thereof is slightly over top dead centre and thus the action of the fingers 2 on the crank portion 14 serves to retain the lever 10 in its first position. The connector can thus be left with the lever 10 in its first position (Figure 2) with the fingers 2 held out of contact with the substrate conductors 200 should this be necessary when no cable is connected by the connector.

As shown in Figure 3 the cable 101 rests on the platforms 8 of the end flanges 5 of the body member 1 and is formed with holes (not shown) in which the hooks 9 on the platforms 8 are received to prevent the cable 101 from being pulled out of the connector.

When the cable 101 is to be removed from the connector the lever 10 is rotated to its first position shown in Figures 1, 2 and 4, and the cable 101 then lifted from the hooks 9 and withdrawn.

It will be appreciated that with the lever 10 in its second position shown in Figure 3 and with no cable in the connector, the fingers 2 will directly engage the substrate conductors 200 and short circuit them all together. If this is undesirable the connector, or at least the parts of the fingers 2 which would engage the substrate conductors 200, can be given a coating of an insulating material.

Referring now to Figures 5 to 8, the connector here shown is similar to that shown in Figures 1 to 4, and corresponding parts have been given the same reference numerals.

In this connector the tail portions 4 of each finger 2 is bent to extend beyond the body member 1 in the direction away from the substrate 201 when the connector is mounted thereon, and is then bent to extend towards the reverse bend in the finger 2, the tip of the finger 2 finally being bent to extend towards the body member 1.

The lifting lever 10 is constituted by a moulded plastics material member in the form of a flat plate 20 having a flange 21 at each end, a row of elongate apertures 22 adjacent one longitudinal edge, and four tapered pegs 23 (only one shown) projecting at spaced intervals from the other longitudinal edge and in the same direction as the end flanges 21.

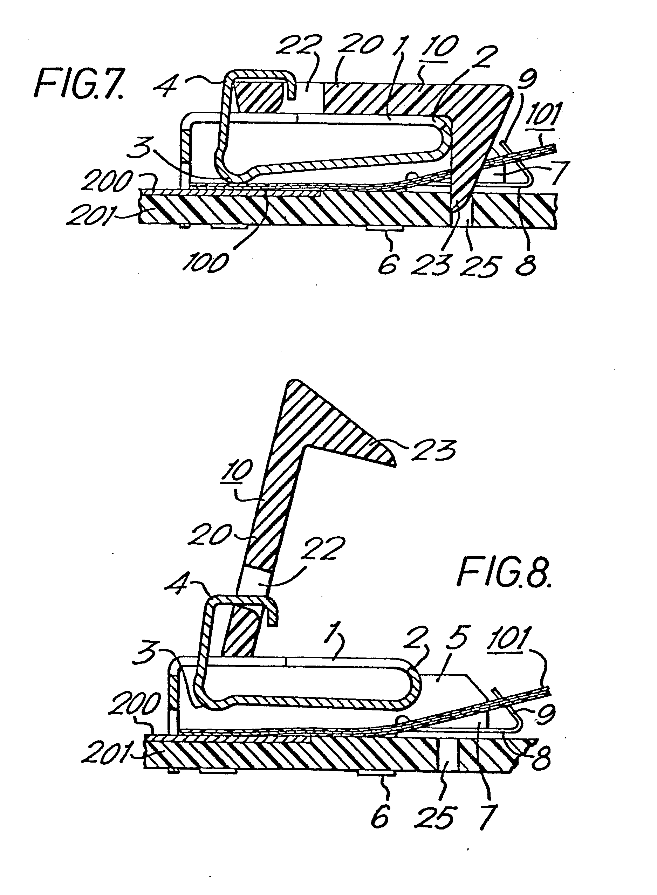

The lifting lever 10 is assembled to the remainder of the connector by engagement of the hooked tail portions 4 of the fingers 2 in the apertures 22 in the lifting lever 10, as clearly shown in Figures 7 and 8. This engagement secures the lifting lever 10 to the body member 1 such that it is pivotable between a first position, shown in Figure 8 in which the lifting lever 10 extends generally away from the substrate 201 and the fingers 2 are held away from the substrate 201 to permit insertion of the prepared end of cable 101 as previously described with reference to Figure 2, and a second position, shown in Figure 7, in which the plate portion 20 of the lifting lever 10 is superposed on the body member 1 and the fingers 2 are in resilient engagement with the inserted cable 101, as previously described with reference to Figure 3. In the second position of the lifting lever 10 the end flanges 21 thereof embrace the ends of the body member 1 while the pegs 23 thereof project through holes 24 formed in the cable 101 and into holes 25 in the substrate 201 thereby secure the cable 101 in the assembly.

As clearly shown in Figures 7 and 8, the edge of the plate portion 20 of the lifting lever 10 which engages the body member 1 when the lifting lever 10 is in its first position (Figure 8) is angled relative to the major surfaces of the plate portion 20 such that movement of the lifting lever 10 from its second position (Figure 7) past the first position is resisted, such movement requiring the lifting lever to pivot about an edge and involving further bending of the fingers 2. A user is thus given a positive indication that the first position has been reached. The lifting lever 10 will however remain in its first position under the action of the fingers 2.

As with the connector of Figures 1 to 4, the metal parts of the connector of Figures 5 to 8, or at least the parts of the fingers 2 which would engage the substrate conductors 200 or an inserted cable 101, can be given an insulating material coating in order to prevent short circuits.

The connectors described above have the advantages that they include a lifting lever which is permanently secured to the connector and which cannot therefore be lost, and which does not require there to be access to the connector from the side thereof remote from the cable-insertion side. Further, the lifting lever is such that the connector can be latched in a condition in which the fingers are held out of contact with the substrate conductor, short circuits thus being prevented without the need for continual manual pressure on the lifting lever.

## Claims

1. A connector, for use in establishing electrical connections between the conductors of a flat multi-conductor electrical cable (101) and conductors (200) carried by a substrate (201), the connector comprising an elongate body member (1) stamped and formed from sheet metal and having a plurality of resilient fingers (2) arranged in a row extending lengthwise of the body member, the fingers all extending in same direction from one longitudinal edge of the body member with their longitudinal axes extending transversely of the row direction, each finger being reversely bent to underlie the body member, and the body member being formed with mounting means (6) comprising a plurality of tabs adapted to pass through holes in a substrate (201) on which the connector is mounted and thereafter to be bent to engage the surface of the substrate remote from the surface of the substrate carrying the conductors, the fingers then extending towards and engaging the conductors carried by the substrate, characterised by a lifting lever (10) mounted on the body member (1) and engageable with the fingers (2), the lifting lever (10) being movable relative to the body member (1), when the connector is mounted on a substrate (201), between a first position in which the lifting lever (10) engages the fingers (2) and lifts them out of contact with the substrate (201), and a second position in which the fingers (2) are permitted to engage the substrate (201).

2. A connector as claimed in Claim 1, characterised in that the lifting lever (10) is made of stiff wire and has the form of a crank supported by flanges (5) formed on the body member (1).

3. A connector as claimed in Claim 2, characterised in that portions (12, 13) of the lifting lever (10) outside the end flanges (5) of the body member (1) are bent to engage a substrate (201) when the connector is mounted thereon, and to form a crank portion (14) underlying tail portions (4) of the fingers (2), which crank portion (14) engages the tail portions (4) of the fingers (2) when the lifting lever (10) is in its first position (Figures 1, 2 and 4) and lifts the fingers (2) away from the substrate (201), the crank portion (14) being clear of the tail portions (4) of the fingers (2) when the lifting lever (10) is in its second position (Figure 3).

4. A connector as claimed in Claim 3, characterised in that the end portions (13, 14) of the lifting lever (10) engage the substrate (201) to prevent movement of the lifting lever (10) beyond its first or second position in the direction away from its second or first position respectively, one end portion (13) serving as a handle for use in effecting movement of the lifting lever (10).

5. A connector as claimed in Claim 3 or Claim 4, characterised in that the crank portion (14) of the lifting lever (10) is bowed in the direction away from the substrate (201) when the lifting lever (10) is in its first position.

6. A connector as claimed in Claim 1, characterised in that each finger (2) has a hooked tail portion (4) bent to extend beyond the body member (1) in the direction away from a substrate (201) when the connector is mounted thereon, and is then bent to extend towards the reverse bend in the finger (2), the tip of the finger (2) being bent to extend towards the body member (1), and in that the lifting lever (10) is a flat plate member (20) having a row of apertures (22) adjacent one longitudinal edge, the tail portions (4) of the fingers (2) being engaged in the apertures (22) in the flat plate member (20), the flat plate member (20) being pivotable between its first position (Figure 8) in which the flat plate member (20) extends generally away from the substrate (201) and the fingers (2) are held away from the substrate (201), and its second position (Figure 7) in which the flat plate member (20) is superposed on the body member (1).

7. A connector as claimed in Claim 6, characterised in that the flat plate member (20) has a flange (21) at each end, which flanges (21) embrace the ends of the body member (1) when the flat plate member (20) is in its second position (Figures 5 and 7).

8. A connector as claimed in Claim 6 or Claim 7, characterised in that the flat plate member (20) is formed with a plurality of tapered pegs (23) projecting from the other longitudinal edge which pegs (23) project through holes (24) in a cable (101) when connected to the connector, and into holes (25) in the substrate (201).

9. A connector as claimed in Claim 6, Claim 7, or Claim 8, characterised in that the edge of the flat plate member (20) which engages the body member (1) when the lifting lever (10) is in its first position is angled relative to the major surfaces of the flat plate member (20) such that movement of the lifting lever (10) from its second position past its first position is resisted.

10. A connector as claimed in any preceding claim, characterised in that at least those parts of the connector which can engage conductors on a substrate on which the connector is mounted or engage a cable (101) when connected to the connector, have an insulating material coating.

## Patentansprüche

1. Verbinder zur Verwendung beim Herstellen elektrischer Verbindungen zwischen den Leitern eines elektrischen Mehrleiter-Flachkabels (101) und Leitern (200), die von einem Substrat (201) getragen werden, welcher Verbinder einen langgestreckten, aus Blech gestanzten und geformten Körperteil mit einer Mehrzahl elastischer Finger (2) aufweist, die in einer sich in der Länge des Körperteils erstreckenden Reihe angeordnet sind und sich alle in derselben Richtung von einer Längskante des Körperteils weg erstrecken, mit ihren Längsachsen quer zur Reihenrichtung, wobei jeder Finger so zurückgebogen ist, daß er unter dem Körperteil liegt, das mit Befestigungsmitteln (6) ausgebildet ist, die eine Mehrzahl von Laschen enthalten, die so ausgebildet sind, daß sie durch Öffnungen in einem Substrat (201), auf dem der Verbinder befestigt ist, hin durchtreten und dann umgebogen werden, so daß sie an derjenigen Fläche des Substrats angreifen, die von der Fläche des Substrats abgewandt ist, die die Leiter trägt, wobei die Finger sich dann auf die vom Substrate getragne Leiter zu erstrecken und an diesen augreifen, gekennzeichnet durch einen Abhebehebel (10), der am Körperteil (1) befistigt ist und an den Fingern (2) angreifen kann, wobei der Abhebehebel (10), wenn der Verbinder auf einem Substrat (201) befestigt ist, gegenüber dem Körper (1) zwischen einer ersten Position, in der der Abhebehebel (10) an den Fingern (2) angreift und diese vom Kontakt mit dem Substrat (201) abhebt, und einer zweiten Position bewegbar ist, in der die Finger (2) am Substrat (201) angreifen können.

2. Verbinder nach Anspruch 1, dadurch gekennzeichnet, daß der Abhebehebel (10) aus steifem Draht gefertigt ist und die Form einer Kurbel aufweist, die von am Körperteil (1) ausgebildeten Flanschen (5) gehalten wird.

3. Verbinder nach Anspruch 2, dadurch gekennzeichnet, daß Teile (12, 13) des Abhebehebels (10) außerhalb der Endflansche (5) des Körperteils (1) so gebogen sind, daß sie an einem Substrat (201) angreifen wenn der Verbinder auf diesem befestigt ist, und daß sie einen Kurbelteil (14) bilden, der unter Endbereichen (4) der Finger (2) liegt, wobei der Kurbelteil (14) an den Endbereichen (4) der Finger (2) angreift wenn sich der Abhebehebel (10) in seiner ersten Position (Fig. 1, 2 und 4) befindet und die Finger (2) vom Substrat (201) abhebt, und welcher Kurbelteil (14) von den Endbereichen (4) der Finger (2) getrennt ist, wenn der Abhebehebel (10) sich in seiner zweiten Position (Fig. 3) befindet.

4. Verbinder nach Anspruch 3, dadurch gekennzeichnet, daß die Endbereiche (13, 14) des Abhebehebels (10) am Substrat (201) anliegen, um eine Bewegung des Abhebehebels (10) über seine erste oder zweite Position in einer Richtung weg von seiner zweiten bzw. ersten Position hinaus zu vermeiden, wobei der eine Endbereich (13) als Griff zum Herbeiführen der Bewegung des Abhebehebels (10) dient.

5. Verbinder nach Anspruch 3 oder Anspruch 4, dadurch gekennzeichnet, daß der Kurbelteil (14) des Abhebehebels (10) vom Substrat (201) weggebogen ist, wenn sich der Abhebehebel (10) in seiner ersten Position befindet.

6. Verbinder nach Anspruch 1, dadurch gekennzeichnet, daß jeder Finger (20) einen hakenförmigen Endbereich (4) aufweist, der so gebogen ist, daß er sich über den Körperteil (1) hinaus vom Substrat (201) weg erstreckt, wenn der Verbinder an diesem befestigt ist, und dann so gebogen ist, daß er sich in Richung zur Rückbiegung im Finger (2) erstreckt, wobei die Spitze des Fingers (2) so gebogen ist, daß sie sich auf den Körperteil (1) hin erstreckt, und daß der Abhebehebel (10) in Flachplattenteil (20) ist, das eine Reihe von Öffnungen (22) entlang einer Längskante aufweist, wobei die Endbereiche (4) der Finger (2) in die Öffnungen (22) in dem Flachplattenteil (20) eingreifen, welches Flachplattenteil (20) schwenkbar ist zwischen seiner ersten Position (Fig. 8), in der sich das Flachplattenteil (20) im wesentlichen vom Substrat (201) weg erstreckt und die Finger (2) vom Substrat (201) weggehalten werden, und seiner zweiten Position (Fig. 7), in der das Flachplattenteil (20) auf den Körperteil (1) aufgelegt ist.

7. Verbinder nach Anspruch 6, dadurch gekennzeichnet, daß das Flachplattenteil (20) einen Flansch (21) an jedem Ende aufweist, welche Flansche (21) die Enden des Körperteils (1) umschließen, wenn sich das Flachplattenteil (20) in seiner zweiten Position befindet (Fig. 5 und 7).

8. Verbinder gemäß Anspruch 6 oder Anspruch 7, dadurch gekennzeichnet, daß das Flachplattenteil (20) mit einer Mehrzahl verjüngter Nasen (23) ausgebildet ist, die sich von der anderen Längskante aus erheben, wobei die Nasen (23) durch Löcher (24) in einem mit dem Verbinder verbundenen Kabel (101) und in Löcher (25) im Substrat (201) hineinragen.

9. Verbinder nach Anspruch 6, Anspruch 7 oder Anspruch 8, dadurch gekennzeichnet, daß die Kante des Flachplattenteils 20, die am Körperteil (1) anliegt, wenn sich der Abhebehebel (10) in seiner ersten Position befindet, gegenüber den Hauptoberflächen des Flachplattenteils (20) so abgewinkelt ist, daß einer Bewegung des Abhebehebels (10) von seiner zweiten Position über seine erste Position hinaus widerstanden wird.

10. Verbinder gemäß einem der vorstehenden Ansprüche, dadurch gekennzeichnet, daß zumindest diejenigen Teile des Verbinders, die an Leitern auf einem Substrat, auf dem der Verbinder befestigt ist, oder ein Kabel (101), wenn dieses mit dem Verbinder verbunden ist, angreifen können, eine Abdeckung mit einem isolierenden Material aufweisen.

**Revendications**

1. Connecteur, à utiliser pour établir des connexions électriques entre les conducteurs d'un câble électrique plat (101) à conducteurs multiples et des conducteurs (200) portés par un substrat (201), le connecteur comprenant un corps allongé (1) embouti et formé en métal en feuille et ayant plusieurs doigts élastiques (2) disposés en une rangée s'étendant longitudinalement au corps, tous les doigts s'étendant dans la même direction d'un bord longitudinal du corps, leurs axes longitudinaux s'étendant transversalement à la direction de la rangée, chaque doigt étant coudé en arrière pour passer sous le corps, et le corps étant formé avec des moyens (6) de montage comprenant plusieurs pattes conçues pour passer dans des trous d'un substrat (201) sur lequel le connecteur est monté, puis être ensuite pliées pour porter contre la surface du substrat éloignée de la surface du substrat portant les conducteurs, les doigts s'étendant alors vers et portant contre les conducteurs portés par le substrat, caractérisé par un levier (10) de soulèvement monté sur le corps (1) et pouvant porter contre les doits (2), le levier (10) de soulèvement étant mobile par rapport au corps (1), lorsque le connecteur est montés sur un substrat (201), entre une première position dans laquelle le levier (10) de soulèvement porte contre les doigts (2) et les soulève et les écarte du substrat (201), et une seconde position dans laquelle les doigts (2) peuvent porter contre le substrat (201).

2. Connecteur selon la revendication 1, caractérisé en ce que le levier (10) de soulèvement est réalisé en fil métallique rigide et présente la forme d'une manivelle supportée par des rebords (5) formés sur le corps (1).

3. Connecteur selon la revendication 2, caractérisé en ce que des parties (12, 13) du levier (10) de soulèvement extérieures aux rebords extrêmes (5) du corps (1) sont coudées pour porter contre un substrat (201) lorsque le connecteur est monté sur ce dernier, et pour former une manivelle (14) passant sous des queues (4) des doigts (2), laquelle manivelle (14) porte contre les queues (4) des doigts (2) lorsque le levier (10) de soulèvement est dans sa première position (figures 1, 2 et 4) et soulève les doigts (2) à l'écart du substrat (201), la manivelle (14) étant dégagée des queues (4) des doigts (2) lorsque le levier (10) de soulèvement est dans sa seconde position (figure 2).

4. Connecteur selon la revendication 3, caractérisé en ce que les tronçons extrêmes (13, 14) du levier (10) de soulèvement portent contre le substrat (201) pour empêcher un mouvement du levier (10) de soulèvement audelà de sa première ou sa seconde position dans la direction s'éloignant de sa seconde ou de sa première position, resectivement, un tronçon extrême (13) servant de poignée et utilisé pour effectuer le mouvement du levier (10) de soulèvement.

5. Connecteur selon la revendication 3 ou la revendication 4, caractérisé en ce que la manivelle (14) du levier (10) de soulèvement est cintrée dans la direction s'éloignant du substrat (201) lorsque le levier (10) de soulèvement est dans sa première position.

6. Connecteur selon la revendication 1, caractérisé en ce que chaque doigt (2) comporte une queue (4) en forme de crochet coudée pour s'étendre au-delà du corps (1) dans la direction s'éloignant d'un substrat (201) lorsque le connecteur est monté sur ce dernier, et est ensuite coudé pour s'étendre vers le coude de retour en arrière du doigt (2), l'extrémité du doigt (2) étant coudée pour s'étendre vers le corps (1), et un ce que le levier (10) de soulèvement est une plaque plane (20) ayant une rangée d'ouvertures (22) adjacentes à un bord longitudinal, les queues (4) des doigts (2) étant engagées dans les ouvertures (22) de la plaque plane (20), la plaque plane (20) pouvant pivoter entre sa première position (figure 8) dans laquelle la plaque plane (20) s'éloigne sensiblement du substrat (201) et les doigts (2) sont maintenus écartés du substrat (201), et sa seconde position (figure 7) dans laquelle la plaque plane (20) est superposée au corps (1).

7. Connecteur selon la revendication 6, caractérisé en ce que la plaque plane (20) comporte un rebord (21) à chaque extrémité, lesquels rebords (21) encadrent les extrémités du corps (1) lorsque la plaque plane (20) est dans sa seconde position (figures 5 et 7).

8. Connecteur selon la revendication 6 ou la revendication 7, caractérisé en ce que la plaque plane (20) comporte plusieurs pieds coniques (23) faisant saillie de l'autre bord longitudinal, lesquels pieds (23) font saillie à travers des trous (24) dans un câble (101) lorsqu'il est connecté au connecteur, et dans des trous (25) du substrat (201).

9. Connecteur selon la revendication 6, la revendication 7 ou la revendication 8, caractérisé en ce que le bord de la plaque plane (20) qui porte contre le corps (1) lorsque le levier (10) de soulèvement est dans sa première position est incliné par rapport aux surfaces principales de la plaque plane (20) afin q'un mouvement du levier (10) de soulèvement à partir de sa seconde position au'delà de sa première position rencontre une résistance.

10. Connecteur selon l'une quelconque des revendications précédentes, caractérisé en ce qu'au moins les parties du connecteur qui peuvent porter contre les conducteurs d'un substrat sur lequel le connecteur est monté ou porter contre un câble (101) lorsqu'il est connecté au connecteur ont un revêtement de matière isolante.

FIG.1.

201

11

1

I

I

10

13

IV

IV

7

9

8

IV

IV

12

5 6

2 7 9

200

0026 568

FIG.4.

13

5

14

1

5

10

2

2

6

2 201

5 200

6

5

6

**0 026 568**

FIG.2.

FIG.3.

FIG.5.

FIG.6.

FIG.7.

FIG.8.